# EUROPÄISCHE PATENTSCHRIFT

(11) **EP 2 814 788 B1**
(45) Veröffentlichungstag und Bekanntmachung des Hinweises auf die Patenterteilung: **08.05.2019**
(21) Anmeldenummer: 13710284.4
(22) Anmeldetag: 13.02.2013
(51) Int. Cl.: C04B 37/02, B32B 15/20, B32B 15/04, B32B 9/00

(54) **METALL-KERAMIK-SUBSTRAT SOWIE VERFAHREN ZUM HERSTELLEN EINES DERARTIGEN METALL-KERAMIK-SUBSTRATES**
METAL-CERAMIC SUBSTRATE AND METHOD FOR PRODUCING SUCH A METAL-CERAMIC SUBSTRATE
SUBSTRAT MÉTALLIQUE/CÉRAMIQUE AINSI QUE PROCÉDÉ PERMETTANT DE FABRIQUER UN TEL SUBSTRAT MÉTALLIQUE/CÉRAMIQUE

(30) Priorität: 15.02.2012 DE 102012101201; 27.03.2012 DE 102012102611
(43) Veröffentlichungstag der Anmeldung: 24.12.2014
(73) Patentinhaber: Rogers Germany GmbH, 92676 Eschenbach (DE)
(72) Erfinder: MEYER, Andreas, 93173 Wenzenbach (DE); WEHE, Christoph, 92676 Speinshart (DE); SCHULZ-HARDER, Jürgen, 91207 Lauf (DE); SCHMIDT, Karsten, 92676 Eschenbach (DE)
(74) Vertreter: Müller Schupfner & Partner Patent- und Rechtsanwaltspartnerschaft mbB
(86) Internationale Anmeldenummer: PCT/DE2013/100054
(87) Internationale Veröffentlichungsnummer: WO 2013/120486

(56) Entgegenhaltungen:
- EP-A2- 0 676 800
- EP-A2- 2 530 707
- JP-A- 2011 183 798
- US-A- 6 033 787

## Beschreibung

Die Erfindung bezieht sich auf ein Metall-Keramik-Substrat gemäß dem Oberbegriff des Patentanspruches 1 sowie ein Verfahren zum Herstellen eines Metall-Keramik-Substrates gemäß dem Oberbegriff des Patentanspruches 11.

Metall-Keramik-Substrate in Form von Leiterplatten bestehend aus einer Isolierschicht aus Keramik, aus wenigstens einer mit einer Oberflächenseite der Isolierschicht aus Keramik verbundenen und zur Ausbildung von Leiterbahnen, Kontakten, Kontakt- oder Befestigungsbereichen strukturierten Metallisierung sind in verschiedensten Ausführungen bekannt.

Von besonderer Bedeutung ist hierbei die Kühlung derartiger Metall- Keramik-Substrate, welche beispielsweise durch direkten Kontakt der der strukturierten Metallisierung gegenüberliegenden Oberflächenseite der Keramik oder einer mit dieser in wärmeleitenden Verbindung stehenden Metallisierung mit einem Kühlmedium oder einem Kühlkörper erfolgen kann. Insbesondere bei Verwendung von fluiden oder gasförmigen Kühlmedium bestehen besondere Anforderungen an das Metall-Keramik- Substrate beispielsweise im Hinblick auf Korrosionsbeständigkeit und Güte der Wärmeleitfähigkeit. Beim Einsatz derartiger Substrate im Kraftfahrzeugbereich ist es beispielsweise wünschenswert, den zur Kühlung des Fahrzeuges vorgesehen Kühlmittelkreislauf auch zur Kühlung des Substrates zu verwenden.

Bekannt ist beispielsweise auch das sogenannte "DCB-Verfahren" ("Direct- Copper-Bonding") zum Verbinden von Metallschichten oder -blechen, vorzugsweise Kupferblechen oder -folien mit einander und/oder mit Keramik oder Keramikschichten, und zwar unter Verwendung von Metall - bzw. Kupferblechen oder Metall- bzw. Kupferfolien, die an ihren Oberflächenseiten eine Schicht oder einen Überzug ("Aufschmelzschicht") aus einer chemischen Verbindung aus dem Metall und einem reaktiven Gas, bevorzugt Sauerstoff aufweisen. Bei diesem beispielsweise in der US-PS 37 44120 oder in der DE-PS 2319854 beschriebenen Verfahren bildet diese Schicht oder dieser Überzug ("Aufschmelzschicht") ein Eutektikum mit einer Schmelztemperatur unter der Schmelztemperatur des Metalls (z.B. Kupfers), so dass durch Auflegen der Metall- bzw. Kupferfolie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht. Ein derartiges DCB-Verfahren weist dann beispielsweise folgende Verfahrensschritte auf:
- Oxidieren einer Kupferfolie derart, dass sich eine gleichmäßige Kupferoxidschicht ergibt;
- Auflegen des Kupferfolie mit der gleichmäßige Kupferoxidschicht auf die Keramikschicht;
- Erhitzen des Verbundes auf eine Prozesstemperatur zwischen etwa 1025 bis 1083°C, beispielsweise auf ca.1071 °C;
- Abkühlen auf Raumtemperatur.

Ferner ist aus den Druckschriften DE 2213115 und EP-A-153618 das sogenannte Aktivlot-Verfahren zum Verbinden von Metallisierungen bildenden Metallschichten oder Metallfolien, insbesondere auch von Kupferschichten oder Kupferfolien mit einem Keramikmaterial bzw. einer Keramikschicht bekannt. Bei diesem Verfahren, welches speziell auch zum Herstellen von Metall-Keramik-Substraten verwendet wird, wird bei einer Temperatur zwischen ca.800 - 1000°C eine Verbindung zwischen einer Metallfolie, beispielsweise Kupferfolie, und einem Keramiksubstrat, beispielsweise einer Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch eine chemische Reaktion eine Verbindung zwischen dem Hartlot und der Keramik her, während die Verbindung zwischen dem Hartlot und dem Metall eine metallische Hartlöt-Verbindung ist.

Aus der JP 2011 183798 A1 ist eine keramische Schicht bekannt, die an der einen Seite mit einer Kupferschicht und an einer anderen Seite mit einer Aluminiumschicht verbunden ist. Die beiden Schichten sind direkt gebunden und haben alle eine Dicke von 0,6 mm.

Die EP 0 676 800 A2 zeigt eine keramische Schicht, die an der einen Seite direkt mit einer Kupferschicht und an der anderen Seite direkt mit Aluminiumkühllamellen mit einer Dicke von 0,5 mm verbunden ist.

Die US 6 033 787 offenbart eine keramische Schicht, die an einer Seite direkt mit einer Kupferschicht verbunden ist und an der anderen Seite indirekt mit einer Aluminiumschicht. Die Keramikschicht hat eine Dicke von 0,6 mm, die Kupferschicht eine Dicke von 2 mm und die Aluminiumschicht hat eine Dicke von 0,3 mm.

Ausgehend von dem voranstehend genannten Stand der Technik liegt der Erfindung die Aufgabe zugrunde, ein Metall-Keramik-Substrat als auch ein Verfahren zu dessen Herstellung aufzuzeigen, welches zur Kühlung mittels fluiden oder gasförmigen Kühlmedien geeignet ist. Die Aufgabe wird durch ein Metall-Keramik-Substrat bzw. ein Verfahren zu dessen Herstellung gemäß der Patentansprüche 1 bzw.11 gelöst.

Der wesentliche Aspekt des erfindungsgemäßen Metall-Keramik-Substrates ist darin zu sehen, dass die zweite Metallisierung durch eine Schicht aus Aluminium oder einer Aluminiumlegierung gebildet ist. Durch die Verwendung von Aluminium oder einer Aluminiumlegierung zur Ausbildung der zweiten Metallisierung eines Metall-Keramik-Substrates kann besonders vorteilhaft zu Kühlzwecken die zweite Metallisierung in direkten Kontakt mit fluiden oder gasförmigen Kühlmedien gebracht werden, ohne dass hierdurch eine langfristige Beeinträchtigung der Funktionsweise des Metall-Keramik-Substrates beispielsweise durch Korrosion der zweiten Metallisierung hervorgerufen wird. Besonders vorteilhaft ist die zweite Metallisierung aus Aluminium oder einer Aluminiumlegierung gebildet, wobei die Oberfläche der Aluminiumschicht bzw. der Aluminiumlegierung auch eloxiert sein kann. Erfindungsgemäß ist die zweite Metallisierung aus Aluminium oder einer Aluminiumlegierung entweder direkt oder indirekt mit der Keramikschicht verbunden.

In einer Weiterbildung der Erfindung ist das erfindungsgemäße Metall- Keramik-Substrat beispielsweise derart ausgebildet, dass die erste Metallisierung eine Schichtdicke zwischen 0,1 mm und 1,0 mm, vorzugsweise zwischen 0,2 mm und 0,8 mm aufweist und/oder zur Ausbildung von Kontakt- oder Bondflächen strukturiert ist, und/oder dass die zweite Metallisierung aus Aluminium oder einer Aluminiumlegierung eine Schichtdicke zwischen zwischen 0,2 mm und 0,6 mm aufweist, und/oder dass die zweite Metallisierung plattenartig, blechartig und/oder halbschalenartig ausgebildet ist, und/oder dass die Keramikschicht aus einer Oxid-, Nitrid- oder Karbidkeramik wie Aluminiumoxid oder Aluminiumnitrid oder Siliziumnitrid oder Siliziumkarbid oder Aluminiumoxid mit Zirkonoxid hergestellt ist und/oder eine Schichtdicke zwischen 0,2 mm und 1,0 mm, vorzugsweise zwischen 0,3 mm und 0,4 mm aufweist, wobei die vorgenannten Merkmale jeweils einzeln oder in beliebiger Kombination verwendet sein können.

Erfindungsgemäß ist es vorgesehen, dass in die zweite Metallisierung mehrere Ausnehmungen unterschiedlicher Form und/oder Tiefe eingebracht sind und/oder die Oberflächenseite der zweite Metallisierung mit von der Oberflächenseite nach außen abstehenden Kühlelementen unterschiedlicher Form und/oder Höhe versehen ist.

In einer weiteren vorteilhaften Ausführungsvariante ist das erfindungsgemäße Metall-Keramik-Substrat derart ausgebildet, dass die Ausnehmungen kanalartig, schlitzartig, oval, langloch-, kreis- oder rautenförmig ausgebildet sind und/oder sich zumindest abschnittsweise über zumindest ein Viertel der Schichtdicke der zweiten Metallisierung erstrecken, und/oder dass die Ausnehmungen zur Vergrößerung der Oberfläche zweite Metallisierung in Form von Löchern mit mindestens einer Lochtiefe von 0,05 mm realisiert sind, wobei die Anordnung der Löcher vorzugsweise matrixartig erfolgt, und/oder dass die Löcher sich bis zur Oberfläche der Keramikschicht (2) erstrecken und/oder unmittelbar nebeneinander und/oder zumindest abschnittsweise überlappend in die Oberfläche der Keramikschicht (2) eingebracht sind, und/oder dass die Kühlelemente rippenartig, langloch-, kreis- oder rautenförmig ausgebildet sind und/oder eine Höhe von 1 mm bis 10 mm aufweisen, und/oder dass eine dritte Metallisierung vorgesehen ist, die zur Ausbildung eines kanalartigen Aufnahmeraumes zur Führung eines fluiden oder gasförmigen Kühlmediums randseitig mit der zweite Metallisierung verbunden ist, und/oder dass die dritte Metallisierung aus Aluminium, einer Aluminiumlegierung, Edelstahl, einer Magnesiumlegierung oder aus mit Chrom- oder Nickel veredelten Stählen hergestellt ist, wobei die vorgenannten Merkmale wiederum jeweils einzeln oder in beliebiger Kombination vorgesehen sein können.

In einer weiteren erfindungsgemäßen Ausführungsvariante ist die zweite Metallisierung über eine vierte aus einer Schicht aus Kupfer oder einer Kupferlegierung gebildete Metallisierung mit der zweiten Oberflächenseite der Keramikschicht verbunden. Diese indirekte Verbindung der zweiten Metallisierung aus Aluminium oder einer Aluminiumlegierung mit der Keramikschicht über die weitere Schicht aus Kupfer oder einer Kupferlegierung ermöglicht die Ausbildung der zweiten Metallisierung als Abschnitt eines Gehäuses. Vorzugsweise erfolgt die flächige Verbindung zwischen der vierten Metallisierung aus einer Schicht aus Kupfer oder einer Kupferlegierung und der zweiten Metallisierung aus Aluminium oder einer Aluminiumlegierung durch ein "Direct-Aluminium-Bonding"-Verfahren ("DAB-Verfahren") oder durch Kleben unter Verwendung eines Kunststoffklebers oder eines als Kleber geeigneten Polymers, vorzugsweise unter Verwendung eines Klebers, der Carbon-Fasern, insbesondere Carbon- Nanofasern enthält.

Ferner ist Gegenstand der Erfindung eine Anordnung umfassend zumindest zwei Metall-Keramik-Substrate, bei dem zumindest eine der zweiten Metallisierungen der einander gegenüberliegenden Metall-Keramik-Substrate halbschalenartig ausgebildet sind und die gegenüberliegenden Metall- Keramik-Substrate derart miteinander verbunden sind, dass zumindest eine wannenartige Metalleinhausung entsteht. Bevorzugt können die zweiten Metallisierungen jeweils halbschalenartig ausgebildet sind und mehrere Randabschnitte aufweisen, die flanschartige Verbindungsbereiche ausbilden. Die Metall-Keramik-Substrate sind vorzugsweise in den flanschartigen Verbindungsbereichen miteinander verschweißt oder verklebt oder auf sonstige Weise dauerhaft und vorzugsweise flüssigkeitsdicht miteinander verbunden.

Ebenfalls ist Gegenstand der Erfindung ein Verfahren zum Herstellen eines Metall-Keramik-Substrates umfassend zumindest eine Keramikschicht, bei der die erste Oberflächenseite mit mindestens einer ersten Metallisierung und eine der ersten Oberflächenseite gegenüberliegende zweite Oberflächenseite mit mindestens einer zweiten Metallisierung verbunden wird, wobei die erste Metallisierung durch eine Folie oder Schicht aus Kupfer oder einer Kupferlegierung gebildet ist. Besonders vorteilhaft wird die zweite Metallisierung aus Aluminium oder einer Aluminiumlegierung hergestellt, wobei die Oberfläche der zweiten Metallisierung zuvor oder danach eloxiert werden kann.

Das erfindungsgemäße Verfahren ist beispielsweise derart ausgebildet, dass die erste Metallisierung und die Keramikschicht durch Kleben unter Verwendung eines Kunststoffklebers oder eines als Kleber geeigneten Polymers, vorzugsweise unter Verwendung eines Klebers, der Carbon- Fasern, insbesondere Carbon-Nanofasern enthält, verbunden werden, und/oder dass die erste Metallisierung und die Keramikschicht mit Hilfe eines "Direct- Copper-Bonding"-Verfahrens oder eines Aktivlötverfahrens miteinander verbunden werden, und/oder dass die zweite Metallisierung und die Keramikschicht durch ein "Direct- Aluminium-Bonding"-Verfahren ("DAB-Verfahren") oder durch Kleben unter Verwendung eines Kunststoffklebers oder eines als Kleber geeigneten Polymers, vorzugsweise unter Verwendung eines Klebers, der Carbon- Fasern, insbesondere Carbon-Nanofasern enthält, miteinander verbunden werden, und/oder dass die Keramikschicht aus einer Oxid-, Nitrid- oder Karbidkeramik wie Aluminiumoxid oder Aluminiumnitrid oder Siliziumnitrid oder Siliziumkarbid oder Aluminiumoxid mit Zirkonoxid hergestellt wird, und/oder dass die Ausnehmungen mittels Ätzen, einer Laserbehandlung und/oder eines mechanischen Bearbeitungsprozesses, beispielsweise Sägen in die nach außen gerichtete Oberflächenseite der zweiten Metallisierung eingebracht werden, und/oder dass zur Vergrößerung der Oberfläche Ausnehmungen in Form von Löchern mit mindestens einer Lochtiefe von 0,05 mm in die Oberseite der zweiten Metallisierung eingebracht werden, wobei die Anordnung der Löcher vorzugsweise matrixartig erfolgt, und/oder dass zur Vergrößerung der Oberfläche Ausnehmungen in Form von bis zur Oberfläche der Keramikschicht sich erstreckenden und/oder unmittelbar nebeneinander angeordneten und/oder zumindest abschnittsweise überlappenden Löchern in die Oberfläche der Keramikschicht eingebracht werden, und/oder dass die zweite Metallisierung eines Metall-Keramik-Substrats halbschalenartig geformt wird und mit der zweite Metallisierung eines gegenüberliegenden Metall-Keramik-Substrate derart miteinander verbunden werden, dass zumindest eine wannenartige Metalleinhausung entsteht, und/oder dass die beiden Metall-Keramik-Substrate vorzugsweise in einem flanschartigen Verbindungsbereich der zweiten Metallisierungen miteinander verschweißt oder verklebt oder auf sonstige Weise dauerhaft und vorzugsweise flüssigkeitsdicht miteinander verbunden werden und/oder dass die Metalleinhausung in einem ein fluides oder gasförmiges Kühlmedium führendes Metallgehäuse aufgenommen wird, wobei die vorgenannten Merkmale jeweils einzeln oder in beliebiger Kombination verwendet sein können. Erfindungsgemäß ist es in einer Alternative vorgesehen, dass die zweite Metallisierung über eine vierte aus einer Schicht aus Kupfer oder einer Kupferlegierung gebildeten Metallisierung mit der zweiten Oberflächenseite der Keramikschicht verbunden wird. Ferner ist es erfindungsgemäß vorgesehen, dass in die zweite Metallisierung mehrere Ausnehmungen unterschiedlicher Form und/oder Tiefe eingebracht werden und/oder die Oberflächenseite der zweiten Metallisierung mit von der Oberflächenseite nach außen abstehende Kühlelementen unterschiedlicher Form und/oder Höhe versehen wird.

Die Ausdrucke "näherungsweise", "im Wesentlichen" oder "etwa" bedeuten im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im Folgenden anhand der Figuren an Ausführungsbeispielen näher erläutert. Es zeigen:
- Fig.1: eine vereinfachte Schnittdarstellung durch ein erfindungsgemäßes Metall-Keramik-Substrat mit einer zweiten Metallisierung aus Aluminium oder einer Aluminiumlegierung,
- Fig.2: eine vereinfachte Schnittdarstellung eine alternative Ausführungsform durch ein erfindungsgemäßes Metall-Keramik- Substrat mit einer zweiten Metallisierung mit nach außen abstehenden Randabschnitten,
- Fig.3: eine vereinfachte Draufsicht auf ein erfindungsgemäßes Metall- Keramik-Substrat gemäß Figur 2 mit einem über die zweite Metallisierung überstehenden Randabschnitt der Keramikschicht,
- Fig.4: eine vereinfachte Draufsicht auf ein erfindungsgemäßes Metall- Keramik-Substrat gemäß Figur 2 mit zwei über die zweite Metallisierung überstehenden Randabschnitten der Keramikschicht,
- Fig.5: eine vereinfachte Schnittdarstellung eines erfindungsgemäßen Metall-Keramik-Substrates mit einer dritten Metallisierung zur Ausbildung eines Führungskanals,
- Fig.6: eine vereinfachte Schnittdarstellung durch eine Anordnung aus zwei gegenüberliegenden und miteinander über ihre zweiten Metallisierungen verbundenen erfindungsgemäßen Metall-Keramik-Substraten,
- Fig. 7: eine vereinfachte Seitenansicht der Anordnung gemäß Figur 6,
- Fig. 8: eine vereinfachte Schnittdarstellung der Anordnung aus zwei gegenüberliegenden und miteinander über ihre zweiten Metallisierungen verbundenen erfindungsgemäßen Metall- Keramik-Substraten mit nach außen weisenden Kühlelementen,
- Fig.9: eine vereinfachte Schnittdarstellung der Anordnung aus zwei gegenüberliegenden und miteinander über ihre zweiten Metallisierungen verbundenen erfindungsgemäßen Metall- Keramik-Substraten aufgenommen in einen das Kühlmedium führenden Führungskanal,
- Fig. 10: eine vereinfachte Draufsicht auf eine zur Vergrößerung der Oberfläche mit Löchern versehenen zweiten Metallisierung,
- Fig.11: einen schematischer Schnitt entlang der Linie A-A durch die zur Vergrößerung der Oberfläche mit Löchern versehene zweite Metallisierung gemäß Figur 10,
- Fig.12: eine schematische Schnittdarstellung entlang der Linie A-A durch die zur Vergrößerung der Oberfläche mit Löchern größerer Lochtiefe versehene zweite Metallisierung gemäß Figur 10,
- Fig.13: eine schematische Schnittdarstellung durch eine zweite Metallisierung mit unmittelbar aneinander anschließenden und/oder überschneidenden Löchern zur Vergrößerung der Oberfläche und
- Fig.14: eine vereinfachte Schnittdarstellung durch eine alternative Ausführungsvariante eines erfindungsgemäßen Metall-Keramik- Substrates, bei der die zweite Metallisierung aus Aluminium oder einer Aluminiumlegierung indirekt mit der Keramikschicht verbunden ist, und zwar mittels einer vierten Metallisierung.

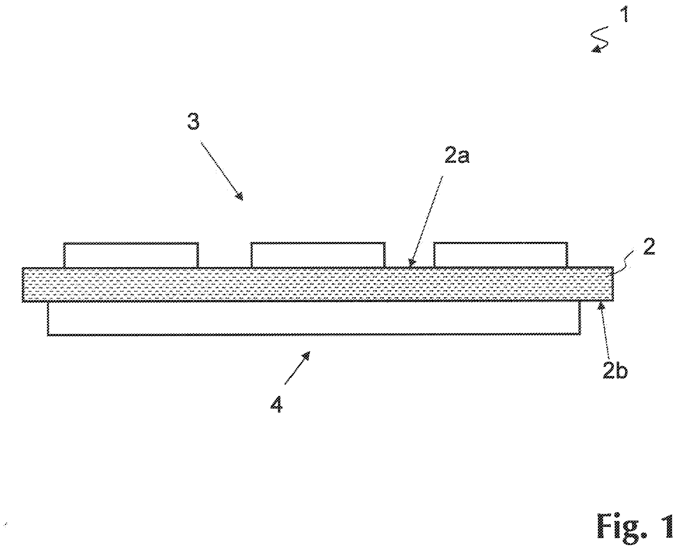

Figur 1 zeigt in vereinfachter Darstellung einen Schnitt durch ein erfindungsgemäßes Metall-Keramik-Substrat 1 umfassend zumindest eine Keramikschicht 2 mit zwei gegenüberliegenden Oberflächenseiten, und zwar einer ersten und zweiten Oberflächenseite 2a, 2b.

Die erste Oberflächenseite 2a ist mit mindestens einer ersten Metallisierung 3 und die der ersten Oberflächenseite 2a gegenüberliegende zweite Oberflächenseite 2b mit mindestens einer zweiten Metallisierung 4 versehen, wobei die erste Metallisierung 3 durch eine Folie oder Schicht aus Kupfer oder einer Kupferlegierung gebildet bzw. hergestellt ist.

Die erste Metallisierung 3 ist vorzugsweise strukturiert ausgebildet, d.h. bildet mehrere Kontaktbereiche bzw. Kontaktflächen zum Anschluss von elektronischen Bauelementen aus. Die erste, aus Kupfer oder einer Kupferlegierung hergestellte Metallisierung 3 weist beispielsweise eine Schichtdicke zwischen 0,1 mm und 1,0 mm, vorzugsweise zwischen 0,2 mm und 0,8 mm auf.

Die Keramikschicht 2 ist beispielsweise aus einer Oxid-, Nitrid- oder Karbidkeramik wie beispielsweise aus Aluminiumoxid (Al2O3) oder Aluminiumnitrid (AIN) oder aus Siliziumnitrid (Si3N4) oder Siliziumkarbid (SiC) oder aus Aluminiumoxid mit Zirkonoxid (Al203 + Zr02) hergestellt und weist eine Schichtdicke beispielsweise zwischen 0,2 mm und 1,0 mm, vorzugsweise zwischen 0,3 mm und 0,4 mm auf.

Erfindungsgemäß ist die zweite Metallisierung 4 durch eine Schicht aus Aluminium oder einer Aluminiumlegierung gebildet. Durch die Verwendung von Aluminium oder einer Aluminiumlegierung zur Ausbildung der zweiten Metallisierung 4 des Metall-Keramik-Substrat 1 kann besonders vorteilhaft zu Kühlzwecken die zweite Metallisierung 4 auch mit fluiden oder gasförmigen Kühlmedien in direkten Kontakt gebracht werden, ohne dass hierdurch eine Beeinträchtigung der Funktionsweise des Metall-Keramik-Substrat 1 beispielsweise durch Korrosion der zweiten Metallisierung 4 hervorgerufen wird.

Darüber hinaus kann die zweite Metallisierung 4 blechartig, plattenartig oder halbschalenartig ausgebildet sein und durch eine Anordnung von zwei Metall-Keramik-Substraten 1 eine zumindest abschnittweise hermetisch versiegelte Einhausung aus Aluminium oder einer Aluminiumlegierung gebildet werden, welche die Keramikschicht 2 mit der strukturierten Metallisierung 3 aufnimmt und die entstehende Wärme an ein die Einhausung zumindest teilweise umströmendes fluides oder gasförmiges Kühlmedium abgibt. Die zweite Metallisierung 4 ist damit zur Herstellung einer direkten wärmeübertragenden Verbindung zu einem fluiden oder gasförmigen Kühlmedium ausgebildet.

Beispielsweise kann bei Verwendung des Metall-Keramik-Substrates 1 im Kraftfahrzeugbereich die Kühlung dessen durch die Aufnahme in den vorhandenen Kühlmittelkreislauf erfolgen. Hierzu wird die zweite Metallisierung 4 des Metall-Keramik-Substrates 1 zumindest abschnittsweise in Kontakt mit dem Kühlmittel gebracht.

Besonders bevorzugt ist die zweite Metallisierung 4 in Form einer eloxierten Schicht aus Aluminium oder einer eloxierten Schicht aus einer Aluminiumlegierung realisiert, um ein Lösen von Aluminium im Kühlmittel, insbesondere in wässrigen Kühlmitteln zu verhindern. Hierbei kann die Eloxierung der Oberfläche vor oder nach der Verbindung mit der Keramikschicht 2 erfolgen.

Die Dicke der die zweite Metallisierung 4 bildenden Schicht aus Aluminium oder einer Aluminiumlegierung beträgt zwischen 0,05 mm und 1 ,0 mm, vorzugsweise zwischen 0,2 mm und 0,6 mm.

Erfindungsgemäß sind in die zweite Metallisierung 4 mehrere Ausnehmungen 5 unterschiedlicher Form und Tiefe eingebracht oder die Oberflächenseite der zweite Metallisierung 4 sind mit Kühlelementen 6 unterschiedlicher Form und Höhe versehen , welche vorteilhafter Weise jeweils die in Wirkverbindung mit dem Kühlmedium tretende Oberfläche der zweite Metallisierung 4 vergrößern.

Die Ausnehmungen 5 können beispielsweise kanalartig, schlitzartig, oval, langloch-, kreis- oder rautenförmig ausgebildet sein und sich abschnittsweise zumindest über ein Viertel der Schichtdicke der zweiten Metallisierung 4 erstrecken. Vorzugsweise weisen die genannten Ausnehmungen 5 eine Ausnehmungstiefe von einem Viertel bis Dreiviertel der Schichtdicke der zweiten Metallisierung 4 auf, d.h. die Ausnehmungstiefe kann beispielsweise zwischen 0,05 mm und 0,9 mm betragen. Die Ausnehmungen 5 werden beispielsweise mittels Ätzen, einer Laserbehandlung und/oder eines mechanischen Bearbeitungsprozesses, beispielsweise Sägen in die nach außen gerichtete Oberflächenseite der zweiten Metallisierung 4 eingebracht.

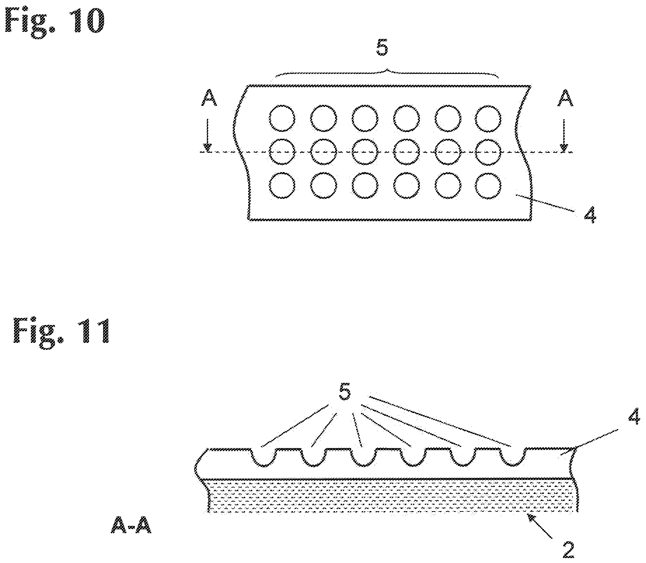

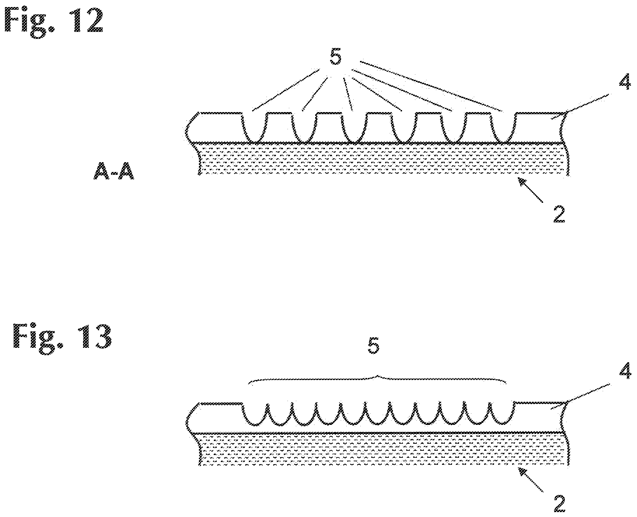

Die Ausnehmungen 5 können beispielsweise zur Vergrößerung der Oberfläche der zweiten Metallisierung 4 in dessen nach außen weisenden Oberseite in Form von Löcher eingebracht sein, und zwar vorzugsweise matrixartig. In Figur 10 ist beispielsweise in einer schematischen Ausschnittsund Draufsichtdarstellung die Oberseite der zweiten Metallisierung 4 mit matrixartig angeordneten Ausnehmungen 5 in Form von Löchern dargestellt. Figur 11 zeigt ebenfalls in einer Ausschnittsdarstellung einen Schnitt entlang der Linie A-A durch die zweite Metallisierung 4 mit anschließender Keramikschicht 2 gemäß der Figur 10. Die durch Löcher gebildeten Ausnehmungen 5 weisen in der dargestellten Ausführungsvariante eine Mindesttiefe von ca.0,05 mm auf und können sich - wie in Figur 12 dargestellt - auch bis zur Oberfläche der Keramikschicht 2 erstrecken. Alternativ können die Löcher 5 - wie in Figur 13 dargestellt - auch unmittelbar nebeneinander und/oder zumindest abschnittsweise überlappend in die Oberfläche der Keramikschicht 2 eingebracht werden. Das in Figur 12 und 13 dargestellte Einbringen von Löcher 5 erfolgt vorzugsweise mittels eines Ätzverfahrens.

Die Kühlelemente 6 können beispielsweise rippenartig, langloch-, kreis- oder rautenförmig ausgebildet sein, welche von der Oberflächenseite der zweiten Metallisierung 4 abstehen. Diese können beispielsweise eine Höhe von 1 mm bis 10 mm aufweisen. Hierbei sind die Kühlelemente 6 und die zweite Metallisierung 4 vorzugsweise einstückig ausgebildet und aus Aluminium oder einer Aluminiumlegierung hergestellt.

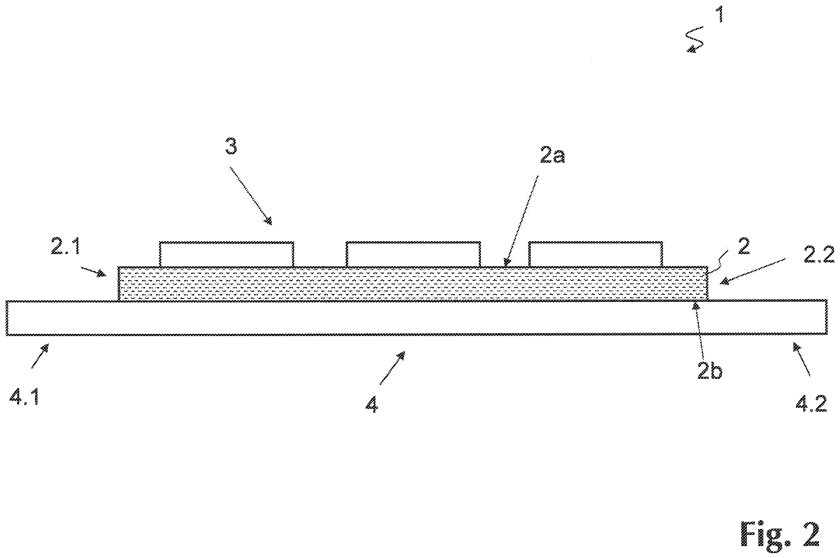

Die aus Aluminium oder einer Aluminiumlegierung hergestellte zweite Metallisierung 4 kann beispielsweise blechartig, plattenartig oder halbschalenartig ausgebildet sein und über den Rand der vorzugsweise ebenen Keramikschicht 2 zumindest abschnittsweise nach außen wegstehen. In Figur 2 ist beispielsweise ein Querschnitt durch ein erfindungsgemäßes Metall-Keramik-Substrates 1 dargestellt, bei dem die Keramikschicht 2 beispielsweise rechteckförmig ausgebildet ist und zwei gegenüberliegende Längsseiten 2.1, 2.2 und zwei gegenüberliegende Querseiten 2.3, 2.4 aufweist. Die aus Aluminium oder einer Aluminiumlegierung hergestellte zweite Metallisierung 4 ist ebenfalls rechteckförmig ausgebildet, wobei zwei gegenüberliegende Randabschnitte 4.1 , 4.2 über die gegenüberliegenden Seitenränder 2.1, 2.2 der Keramikschicht 2 überstehen. Besonders vorteilhaft kann beispielsweise auch der oder die überstehenden Randabschnitt(e) 4.1, 4.2 der zweiten Metallisierung 4 mit dem fluiden oder gasförmigen Kühlmedium in Kontakt gebracht werden.

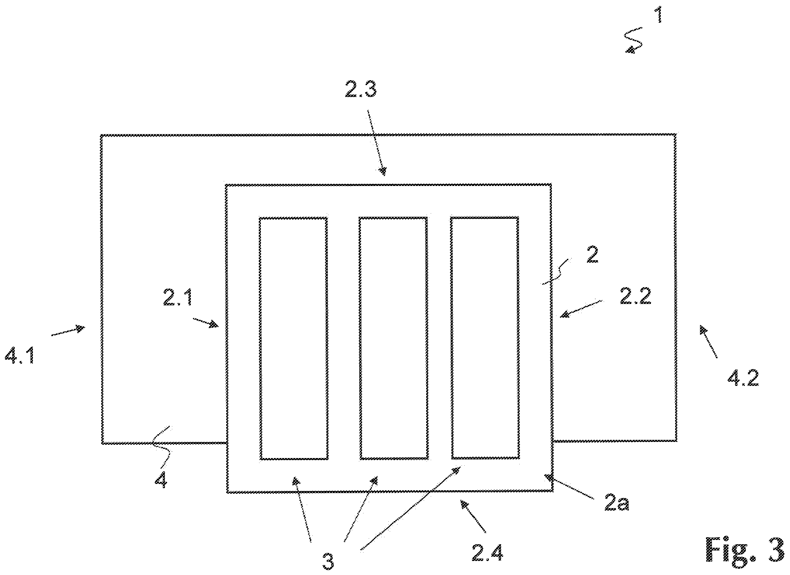

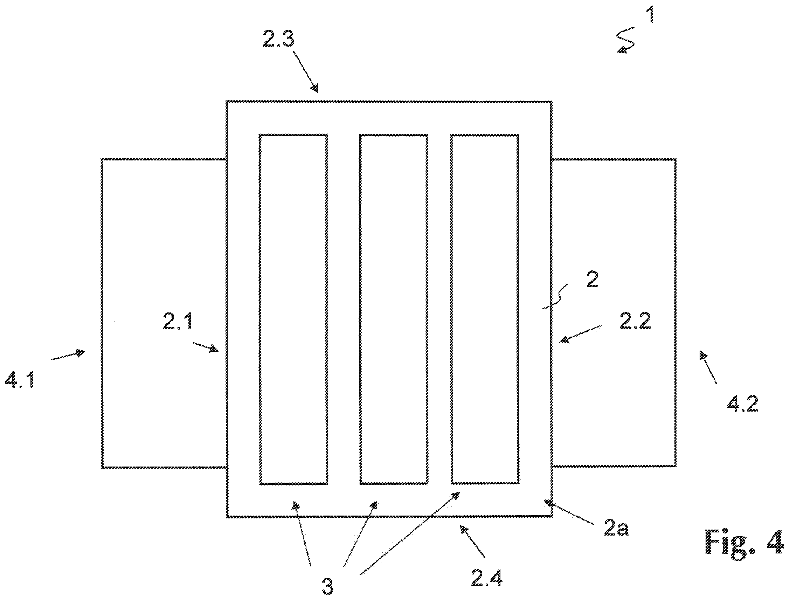

In einer bevorzugten Ausführungsvariante gemäß den Figuren 3 und 4 steht die Keramikschicht 2 des Metall-Keramik-Substrates 1 zumindest mit einer Querseite 2.3, 2.4 über die plattenartige zweite Metallisierung 4 über, d.h. die zweite Metallisierung 4 erstreckt sich in Längsrichtung der rechteckförmigen Keramikschicht 2 lediglich über einen Teil der Keramikschicht 2. Besonders vorteilhaft können an zumindest einer der überstehenden Querseiten 2.3, 2.4 der rechteckförmigen Keramikschicht 2 die elektrischen Anschlüsse für die Beschaltung des Metall-Keramik- Substrates 1 angeordnet werden.

Unter Berücksichtigung der für die Keramikschicht 2 und die Metallisierungen 3, 4 verwendeten Materialien eignen sich für das flächige Verbinden der Keramikschicht 2 mit der ersten bzw. zweiten Metallisierung 3, 4 unterschiedliche Verfahren.

So wird die erste Metallisierung 3 beispielsweise durch Kleben unter Verwendung eines Kunststoffklebers oder eines als Kleber geeigneten Polymers, vorzugsweise unter Verwendung eines Klebers, der Carbon- Fasern, insbesondere Carbon-Nanofasern enthält, mit der Keramikschicht 2 verbunden. Erfindungsgemäß kann die flächige Verbindung der Keramikschicht unter Verwendung des DCB-Verfahrens oder mit Hilfe des Aktivlötverfahrens erfolgen.

Die zweite Metallisierung 4 aus Aluminium oder einer Aluminiumlegierung wird beispielsweise durch ein "Direct-Aluminium-Bonding"-Verfahren ("DAB-Verfahren") mit der Keramikschicht 2 verbunden.

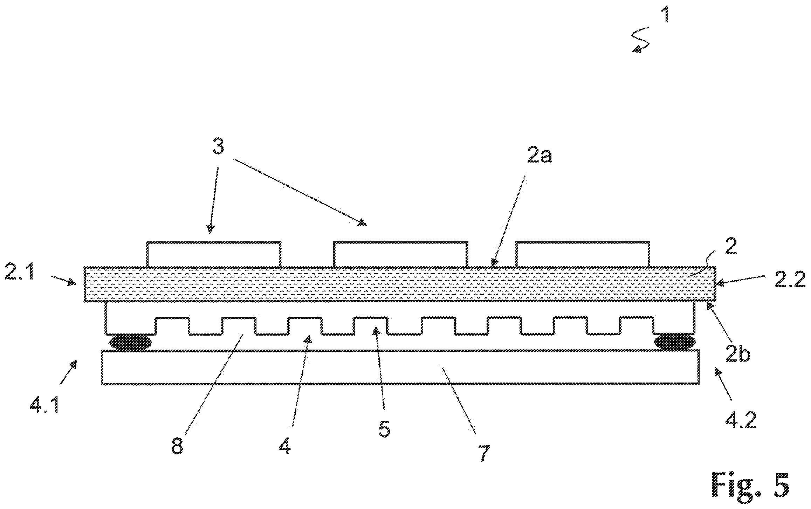

In einer bevorzugten Ausführungsvariante gemäß der Figur 5 wird die mit Ausnehmungen 5 versehene zweite Metallisierung 4 mit einer dritte Metallisierung 7 verbunden, welche beispielsweise aus Aluminium, einer Aluminiumlegierung, Edelstahl, einer Magnesiumlegierung oder aus mit Chrom- oder Nickel veredelten Stählen hergestellt sein kann. Die zweite und dritte Metallisierung 4, 7 sind randseitig miteinander verbunden, und zwar vorzugsweise flüssigkeits- oder gasdicht. Dadurch bildet sich zumindest ein kanalartiger Aufnahmeraum 8 zur Führung des fluidem oder gasförmigen Kühlmediums aus. Vorzugsweise finden Ausnehmungen 5 Anwendung, welche zusammen mit der dritten Metallisierung 7 Längskanäle ausbilden und damit eine gerichtete Führung des fluidem oder gasförmigen Kühlmediums beispielsweise entlang der Längsachse des Substrates 1 ermöglichen.

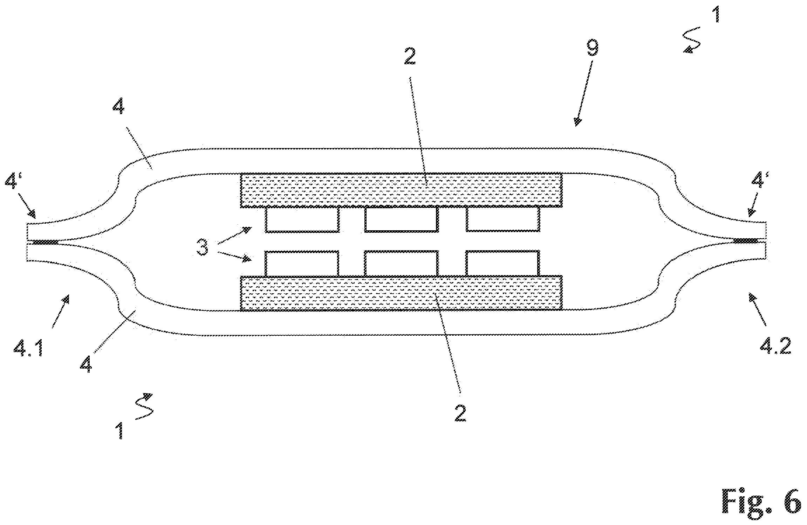

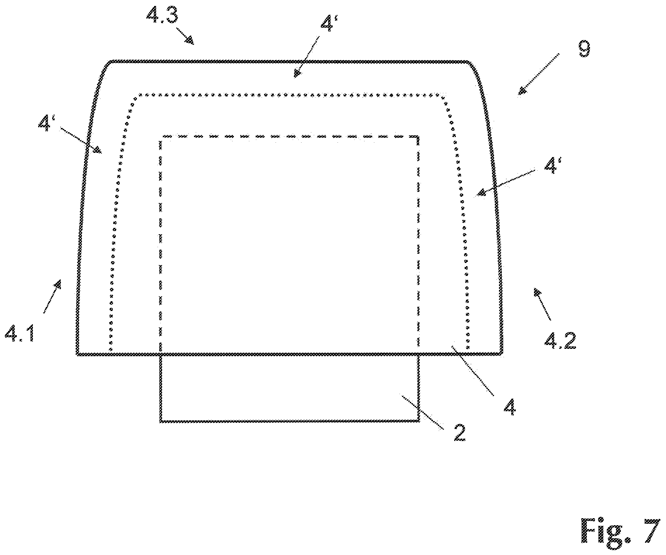

In Figur 6 und 7 ist eine alternative Ausführungsvariante der Erfindung dargestellt, und zwar eine Anordnung aus zwei erfindungsgemäßen Metall- Keramik-Substraten 1 , bei der die Randabschnitte 4.1 , 4.2, 4.3 der zweiten Metallisierung 4 jeweils über die Keramikschicht 3 zumindest abschnittsweise seitlich hinweg stehen und derart in Richtung der Keramikschicht 2 gebogen sind, dass sich jeweils ein flanschartiger Verbindungsbereich 4' ausbildet. Die flanschartigen Verbindungsbereiche 4' der beiden gegenüberliegenden Metall-Keramik-Substrate 1 werden derart miteinander verbunden, dass vorzugsweise eine wannenartige Metalleinhausung 9 entsteht, welche die Keramikschichten 2 und die darauf vorgesehene erste Metallisierungen 3 zumindest teilweise aufnehmen. Die wannenartige Metalleinhausung 9 weist somit eine langlochförmige, stirnseitige Öffnung auf, durch welche die jeweils die ersten Metallisierung 3 aufnehmenden Keramikschichten 2 nach außen geführt werden, um eine Anschlussmöglichkeit zu schaffen.

Die beiden Metall-Keramik-Substrate 1 sind vorzugsweise in den flanschartigen Verbindungsbereichen 4' der zweiten Metallisierung 4 miteinander verschweißt oder verklebt oder auf sonstige Weise dauerhaft und vorzugsweise flüssigkeitsdicht miteinander verbunden.

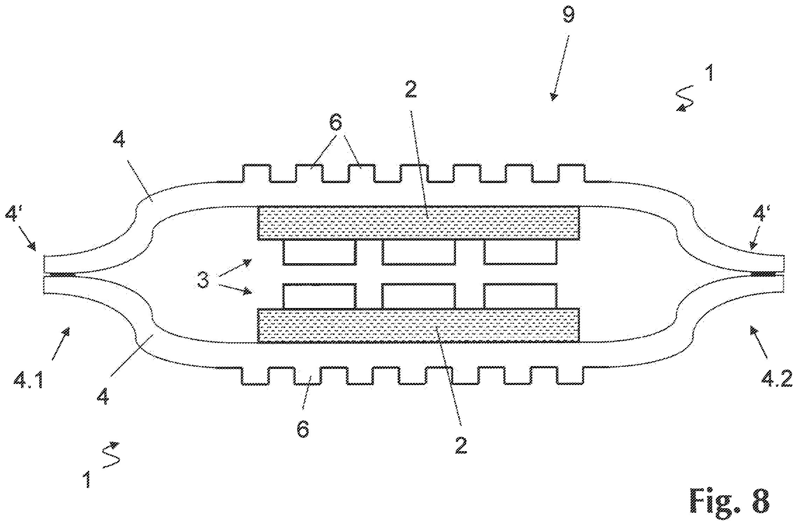

In einer weiteren Ausführungsvariante gemäß Figur 8, welche im Wesentlichen der in Figur 6 dargestellten Anordnung aus zwei erfindungsgemäßen Metall-Keramik-Substraten 1 entspricht, sind an der nach außen gerichteten Oberflächenseite der zweiten Metallisierung 4 der Metall- Keramik-Substrate 1 zuvor beschriebene Kühlelemente 6 vorgesehen, welche beispielsweise rippenartig ausgebildet sind. Diese sind vorzugsweise im der Keramikschicht 2 gegenüberliegenden Bereich der zweiten Metallisierung 4 realisiert.

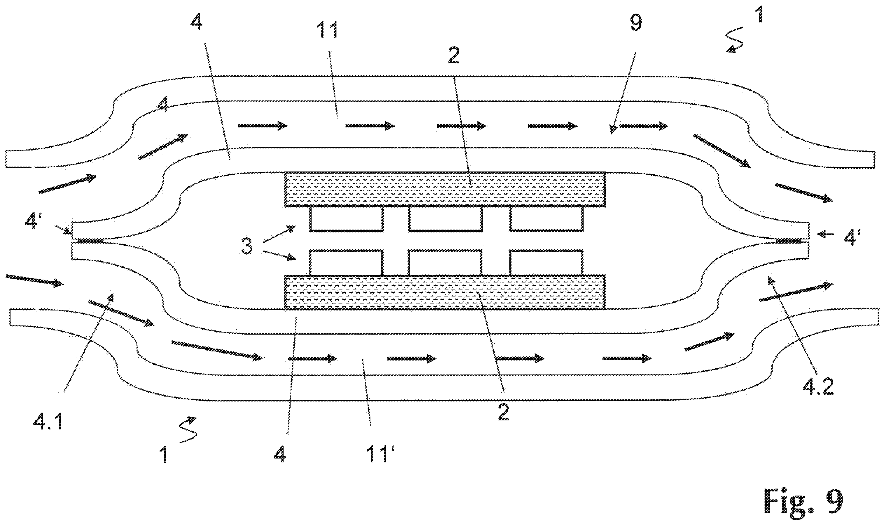

Figur 9 zeigt eine Schnittdarstellung einer weiteren Ausführungsvariante der Erfindung. Hier wird die Anordnung aus zwei erfindungsgemäßen Metall- Keramik-Substraten 1 gemäß Figur 6 und 7 in ein das Kühlmedium führendes Metallgehäuse 10 aufgenommen, so dass sich zumindest zwei Führungskanäle 11, 11' ausbilden, mittels derer das Kühlmedium in Längsrichtung der Anordnung an den Metall-Keramik-Substraten 1 vorbeigeführt wird und dadurch jeweils die zweite Metallisierung 4 der Metall-Keramik-Substrate 1 in direkten Kontakt mit dem Kühlmedium gebracht wird. Eine derartige Ausführungsvariante eignet sich besonders für die Integration der Anordnung aus zwei erfindungsgemäßen Metall-Keramik-Substraten 1 in den Kühlmittelkreislauf eines Kraftfahrzeuges. Hierbei kann die durch die beiden zweite Metallisierungen 4 aus Aluminium oder Aluminiumlegierung gebildete Metalleinhausung 9 entweder wannenartig analog zu Figur 7 oder geschlossen ausgebildet sein, wobei in der geschlossenen Ausführungsform eine hermetisch dichte Durchführung der Anschlussleitungen durch die zweiten Metallisierungen 4 vorzusehen ist, um eine Anschlussmöglichkeit für die auf der ersten Metallisierung 3 aufgenommen elektrischen Bauteile bzw. Schaltung zu schaffen.

Zusätzlich können in einer nicht dargestellten Ausführungsvariante die erste Metallisierung 3 zumindest teilweise mit einer metallischen Oberflächenschicht versehen werden, beispielsweise einer Oberflächenschicht aus Nickel, Silber oder Nickel- und Silber-Legierungen. Eine derartige metallische Oberflächenschicht wird vorzugsweise nach dem Aufbringen der Metallisierung 3 auf die Keramikschicht 2 und deren Strukturieren auf die dadurch entstehenden metallischen Kontaktflächen aufgebracht. Das Aufbringen der Oberflächenschicht erfolgt in einem geeigneten Verfahren, beispielsweise galvanisch und/oder durch chemisches Abscheiden und/oder durch Spritzen oder Kaltgasspritzen. Insbesondere bei Verwendung von Nickel besitzt die metallische Oberflächenschicht beispielsweise eine Schichtdicke im Bereich zwischen 0,002 mm und 0,015 mm. Bei einer Oberflächenschicht aus Silber wird diese mit einer Schichtdicke im Bereich zwischen 0,00015 mm und 0,05 mm, vorzugsweise mit einer Schichtdicke im Bereich zwischen 0,01 m und 3 m aufgebracht. Durch eine derartige Oberflächenbeschichtung der metallischen Kontaktflächen wird das dortige Aufbringen der Lotschicht bzw. des Lotes und die Verbindung des Lotes mit dem Bondbereich der elektrischen Bauteile verbessert.

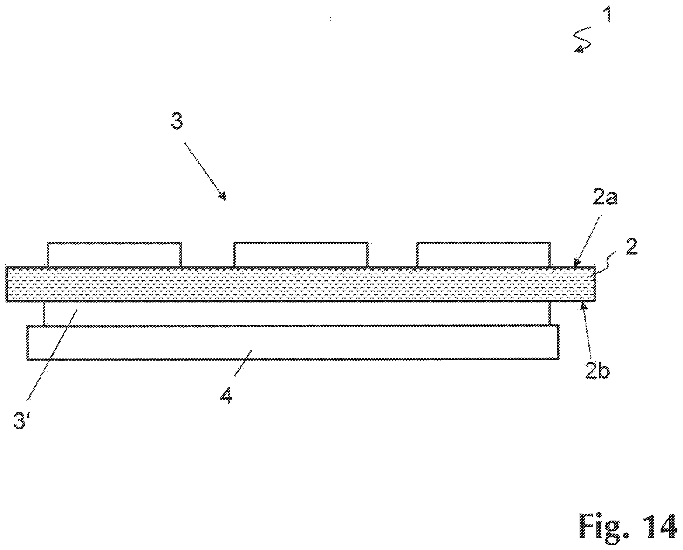

In Figur 14 ist eine weitere Ausführungsvariante eines erfindungsgemäßen Metall-Keramik-Substrates gemäß Figur 1 dargestellt, bei anstelle einer direkten flächigen Verbindung der zweiten Metallisierung 4 mit der Keramikschicht 2 eine indirekte Verbindung über eine vierte Metallisierung 3' vorgesehen ist. Die vierte Metallisierung 3' ist bevorzugt durch eine Schicht aus Kupfer oder Kupferlegierung gebildet, deren eine Oberflächenseite beispielsweise unter Verwendung des DCB-Verfahrens mit der zweiten Oberflächenseite 2b der Keramikschicht 2 verbunden ist. Die gegenüberliegende Oberflächenseite der vierte Metallisierung 3' wird mit der zweiten Metallisierung 2 aus Aluminium oder einer Aluminiumlegierung beispielsweise durch ein "Direct-Aluminium-Bonding"-Verfahren ("DAB- Verfahren") oder durch Kleben unter Verwendung eines Kunststoffklebers oder eines als Kleber geeigneten Polymers, vorzugsweise unter Verwendung eines Klebers, der Carbon-Fasern, insbesondere Carbon-Nanofasern enthält, mit der Keramikschicht 2 verbunden. Diese Ausführungsvariante eignet sich insbesondere für Anwendungsfälle, bei denen die zweite Metallisierung 2 aus Aluminium oder einer Aluminiumlegierung durch zumindest einen flachen Abschnitt eines Gehäuses gebildet ist. Die Erfindung wurde voranstehend an Ausführungsbeispielen beschrieben. Es versteht sich, dass zahlreiche Änderungen sowie Abwandlungen möglich sind, ohne dass dadurch der der Erfindung zugrunde liegend Erfindungsgedanke verlassen wird.

### Bezugszeichenliste:

- 1: Metall-Keramik-Substrat
- 2: Keramikschicht
- 2a: erste Oberflächenseite
- 2b: zweite Oberflächenseite
- 2.1, 2.2: Längsseiten
- 2.3, 2.4: Querseiten
- 3: erste Metallisierung
- 3': vierte Metallisierung
- 4: zweite Metallisierung
- 4': Verbindungsbereiche
- 4.1: Randabschnitt der zweiten Metallisierung
- 4.2: Randabschnitt der zweiten Metallisierung
- 5: Ausnehmungen
- 6: Kühlelemente
- 7: dritte Metallisierung
- 8: Aufnahmeraum
- 9: Metalleinhausung
- 10: Metallgehäuse
- 11, 11': Führungskanäle

## Patentansprüche

1. Metall-Keramik-Substrat umfassend zumindest eine Keramikschicht (2), die an einer ersten Oberflächenseite (2a) mit mindestens einer ersten Metallisierung (3) und an einer der ersten Oberflächenseite (2a) gegenüberliegenden zweiten Oberflächenseite (2b) mit einer zweiten Metallisierung (4) versehen ist, wobei die erste Metallisierung (3) durch eine Folie oder Schicht aus Kupfer oder einer Kupferlegierung gebildet ist, wobei die erste Metallisierung (3) mit Hilfe eines "Direct Copper-Bonding"-Verfahren oder mit Hilfe eines Aktivlotverfahrens mit der ersten Oberflächenseite (2a) der Keramikschicht (2) verbunden ist und bei dem die zweite Metallisierung (4) durch eine Schicht aus Aluminium oder einer Aluminiumlegierung gebildet ist die eine Schichtdicke zwischen 0,2 mm und 3,0 mm aufweist, wobei die zweite Metallisierung (4) aus Aluminium oder einer Aluminiumlegierung entweder direkt oder über eine vierte aus einer Schicht aus Kupfer oder einer Kupferlegierung gebildeten Metallisierung (3') mit der zweiten Oberflächenseite (2b) der Keramikschicht (2) verbunden ist, **dadurch gekennzeichnet, dass** in die zweite Metallisierung (4) mehrere Ausnehmungen (5) unterschiedlicher Form und/oder Tiefe eingebracht sind und/oder die Oberflächenseite der zweite Metallisierung (4) mit von der Oberflächenseite nach außen abstehenden Kühlelementen (6) unterschiedlicher Form und/oder Höhe versehen ist.

2. Metall-Keramik-Substrat nach Anspruch 1, **dadurch gekennzeichnet, dass** die Oberfläche der zweiten Metallisierung (4) aus Aluminium oder einer Aluminiumlegierung eloxiert ist und/oder dass die erste Metallisierung (3) eine Schichtdicke zwischen 0,1 mm und 1,0 mm, vorzugsweise zwischen 0,2 mm und 0,8 mm aufweist und/oder zur Ausbildung von Kontakt- oder Bondflächen strukturiert ist.

3. Metall-Keramik-Substrat nach einem der Ansprüche 1 oder 2, **dadurch gekennzeichnet, dass** die zweite Metallisierung (4) plattenartig, blechartig und/oder halbschalenartig ausgebildet ist.

4. Metall-Keramik-Substrat nach einem der vorhergehenden Ansprüche, **dadurch gekennzeichnet, dass** die Keramikschicht aus Oxid-, Nitrid- oder Karbidkeramiken wie Aluminiumoxid oder Aluminiumnitrid oder Siliziumnitrid oder Siliziumkarbid oder Aluminiumoxid mit Zirkonoxid hergestellt ist und/oder eine Schichtdicke zwischen 0,2 mm und 1,0 mm, vorzugsweise zwischen 0,3 mm und 0,4 mm aufweist.

5. Metall-Keramik-Substrat nach Anspruch 4, **dadurch gekennzeichnet, dass** die Ausnehmungen (5) kanalartig, schlitzartig, oval, langloch-, kreis- oder rautenförmig ausgebildet sind und/oder sich zumindest abschnittsweise über zumindest ein Viertel der Schichtdicke der zweiten Metallisierung (4) erstrecken oder dass die Ausnehmungen (5) zur Vergrößerung der Oberfläche zweite Metallisierung (4) in Form von Löchern mit mindestens einer Lochtiefe von 0,05 mm realisiert sind, wobei die Anordnung der Löcher vorzugsweise matrixartig erfolgt.

6. Metall-Keramik-Substrat nach Anspruch 5, **dadurch gekennzeichnet, dass** die Löcher sich bis zur Oberfläche der Keramikschicht (2) erstrecken und/oder unmittelbar nebeneinander und/oder zumindest abschnittsweise überlappend in die Oberfläche der Keramikschicht (2) eingebracht sind.

7. Metall-Keramik-Substrat nach Anspruch 3, **dadurch gekennzeichnet, dass** die Kühlelemente (6) rippenartig, langloch-, kreis- oder rautenförmig ausgebildet sind und/oder eine Höhe von 1 mm bis 10 mm aufweisen.

8. Metall-Keramik-Substrat nach einem der vorhergehenden Ansprüche, **dadurch gekennzeichnet, dass** eine dritte Metallisierung (7) vorgesehen ist, die zur Ausbildung eines kanalartigen Aufnahmeraumes (8) zur Führung eines fluiden oder gasförmigen Kühlmediums randseitig mit der zweite Metallisierung (4) verbunden ist und dass die dritte Metallisierung (7) aus Aluminium, einer Aluminiumlegierung, Edelstahl, einer Magnesiumlegierung oder aus mit Chrom- oder Nickel veredelten Stählen hergestellt ist.

9. Anordnung umfassend zumindest zwei Metall-Keramik-Substrate (1) nach einem der vorhergehenden Ansprüche, **dadurch gekennzeichnet, dass** zumindest eine der zweiten Metallisierungen (4) der einander gegenüberliegenden Metall-Keramik-Substrate (1) halbschalenartig ausgebildet sind und dass die gegenüberliegenden Metall-Keramik-Substrate (1) derart miteinander verbunden sind, dass zumindest eine wannenartige Metalleinhausung entsteht.

10. Anordnung nach Anspruch 9, **dadurch gekennzeichnet, dass** die zweiten Metallisierungen (4) jeweils halbschalenartig ausgebildet sind und mehrere Randabschnitte (4.1, 4.2, 4.3) aufweisen, die flanschartige Verbindungsbereiche (4') ausbilden und/oder dass die Metall-Keramik-Substrate (1) vorzugsweise in den flanschartigen Verbindungsbereichen (4') miteinander verschweißt oder verklebt oder auf sonstige Weise dauerhaft und vorzugsweise flüssigkeitsdicht miteinander verbunden sind.

11. Verfahren zum Herstellen eines Metall-Keramik-Substrates (2) umfassend zumindest eine Keramikschicht (2), bei der die ersten Oberflächenseite (2a) mit mindestens einer ersten Metallisierung (3) und eine der ersten Oberflächenseite (2a) gegenüberliegende zweite Oberflächenseite (2b) mit mindestens einer zweiten Metallisierung (4) verbunden wird, wobei die erste Metallisierung (3) durch eine Folie oder Schicht aus Kupfer oder einer Kupferlegierung gebildet ist, wobei die erste Metallisierung (3) mit Hilfe eines "Direct Copper-Bonding"- Verfahren oder mit Hilfe eines Aktivlotverfahrens mit der ersten Oberflächenseite (2a) der Keramikschicht (2) verbunden wird und bei dem die zweite Metallisierung (4) durch eine Schicht aus Aluminium oder einer Aluminiumlegierung gebildet wird, die eine Schichtdicke zwischen 0,2 mm und 3,0 mm aufweist, wobei die zweite Metallisierung (4) aus Aluminium oder einer Aluminiumlegierung entweder direkt oder über eine vierte aus einer Schicht aus Kupfer oder einer Kupferlegierung gebildeten Metallisierung (3') mit der zweiten Oberflächenseite (2b) der Keramikschicht (2) verbunden wird **dadurch gekennzeichnet, dass** in die zweite Metallisierung (4) mehrere Ausnehmungen (5) unterschiedlicher Form und/oder Tiefe eingebracht sind und/oder die Oberflächenseite der zweite Metallisierung (4) mit von der Oberflächenseite nach außen abstehenden Kühlelementen (6) unterschiedlicher Form und/oder Höhe versehen ist.

12. Verfahren nach Anspruch 11, **dadurch gekennzeichnet, dass** die zweite Metallisierung (4) eloxiert wird.

13. Verfahren nach Anspruch 12 oder 13, **dadurch gekennzeichnet, dass** die zweite Metallisierung (2) und die Keramikschicht (2) durch ein "Direct-Aluminium-Bonding"-Verfahren ("DAB-Verfahren") oder durch Kleben unter Verwendung eines Kunststoffklebers oder eines als Kleber geeigneten Polymers, vorzugsweise unter Verwendung eines Klebers, der Carbon-Fasern, insbesondere Carbon-Nanofasern enthält, miteinander verbunden werden.

14. Verfahren nach einem der Ansprüche 11 bis 13, **dadurch gekennzeichnet, dass** die Keramikschicht aus Aluminiumoxid oder Aluminiumnitrid oder Siliziumnitrid oder Aluminiumoxid mit Zirkonoxid hergestellt wird.

15. Verfahren nach einem der Ansprüche 11 bis 14, **dadurch gekennzeichnet, dass** die Ausnehmungen (5) mittels Ätzen, einer Laserbehandlung und/oder eines mechanischen Bearbeitungsprozesses, beispielsweise Sägen in die nach außen gerichtete Oberflächenseite der zweiten Metallisierung (4) eingebracht werden.

16. Verfahren nach Anspruch 15, **dadurch gekennzeichnet, dass** zur Vergrößerung der Oberfläche Ausnehmungen (5) in Form von Löchern mit mindestens einer Lochtiefe von 0,05 mm in die Oberseite der zweiten Metallisierung (4) eingebracht werden, wobei die Anordnung der Löcher vorzugsweise matrixartig erfolgt oder zur Vergrößerung der Oberfläche Ausnehmungen (5) in Form von bis zur Oberfläche der Keramikschicht (2) sich erstreckenden und/oder unmittelbar nebeneinander angeordneten und/oder zumindest abschnittsweise überlappenden Löchern in die Oberfläche der Keramikschicht (2) eingebracht werden.

17. Verfahren nach einem der Ansprüche 11 bis 16, **dadurch gekennzeichnet, dass** die zweite Metallisierung (4) eines Metall-Keramik-Substrats (1) halbschalenartig geformt wird und mit der zweite Metallisierung (4) eines gegenüberliegenden Metall-Keramik-Substrate (1) derart miteinander verbunden werden, dass zumindest eine wannenartige Metalleinhausung (9) entsteht, die beiden Metall-Keramik-Substrate (1) vorzugsweise in einem flanschartigen Verbindungsbereich (4') der zweiten Metallisierungen (4) miteinander verschweißt oder verklebt oder auf sonstige Weise dauerhaft und vorzugsweise flüssigkeitsdicht miteinander verbunden werden.

18. Verfahren nach Anspruch 17, **dadurch gekennzeichnet, dass** die Metalleinhausung (9) in einem ein fluides oder gasförmiges Kühlmedium führendes Metallgehäuse (10) aufgenommen wird.

## Claims

1. Metal-ceramic substrate comprising at least one ceramic layer (2) which is provided on a first surface side (2a) with at least one first metallization (3) and on a second surface side (2b) opposite the first surface side (2a) with a second metallization (4), wherein the first metallization (3) is formed by a foil or layer of copper or a copper alloy, the first metallization (3) being bonded to the first surface side (2a) of the ceramic layer (2) by means of a "direct copper bonding" process or by means of an active brazing process, and in which the second metallization (4) is formed by a layer of aluminium or an aluminium alloy, which has a layer thickness between 0.2 mm and 3.0 mm, the second metallization (4) of aluminium or an aluminium alloy being connected either directly or via a fourth metallization (3') formed from a layer of copper or a copper alloy to the second surface side (2b) of the ceramic layer (2), **characterized in that** a plurality of recesses (5) of different shape and/or depth are introduced into the second metallization (4) and/or the surface side of the second metallization (4) is provided with cooling elements (6) of different shape and/or height projecting outwards from the surface side.

2. Metal-ceramic substrate according to claim 1, **characterized in that** the surface of the second metallization (4) of aluminium or an aluminium alloy is anodized and/or in that the first metallization (3) has a layer thickness between 0.1 mm and 1.0 mm, preferably between 0.2 mm and 0.8 mm and/or is structured to form contact or bonding surfaces.

3. Metal-ceramic substrate according to one of claims 1 or 2, **characterized in that** the second metallization (4) is plate-like, sheet-like and/or half-shell-like.

4. Metal-ceramic substrate according to one of the preceding claims, **characterized in that** the ceramic layer is made of oxide, nitride or carbide ceramics such as aluminium oxide or aluminium nitride or silicon nitride or silicon carbide or aluminium oxide with zirconium oxide and/or has a layer thickness between 0.2 mm and 1.0 mm, preferably between 0.3 mm and 0.4 mm.

5. Metal-ceramic substrate according to Claim 4, **characterized in that** the recesses (5) are channel-like, slot-like, oval, slot-like, circular or diamond-shaped and/or extend at least partially over at least one quarter of the layer thickness of the second metallization (4), or **in that** the recesses (5) for enlarging the surface of the second metallization (4) are realized in the form of holes with at least one hole depth of 0.05 mm, the arrangement of the holes preferably being matrix-like.

6. Metal-ceramic substrate according to Claim 5, **characterized in that** the holes extend to the surface of the ceramic layer (2) and/or are introduced into the surface of the ceramic layer (2) directly next to one another and/or overlapping at least partially.

7. A metal-ceramic substrate according to claim 3, **characterized in that** the cooling elements (6) are ribbed, elongated-hole, circular or diamond-shaped and/or have a height of 1 mm to 10 mm.

8. Metal-ceramic substrate according to one of the preceding claims, **characterized in that** a third metallization (7) is provided which is connected at the edge to the second metallization (4) in order to form a channel-like receiving space (8) for guiding a fluid or gaseous cooling medium, and **in that** the third metallization (7) is produced from aluminium, an aluminium alloy, stainless steel, a magnesium alloy or from steels refined with chromium or nickel.

9. Arrangement comprising at least two metal-ceramic substrates (1) according to one of the preceding claims, **characterized in that** at least one of the second metallizations (4) of the mutually opposite metal-ceramic substrates (1) is of half-shell-like construction and **in that** the opposite metal-ceramic substrates (1) are connected to one another in such a way that at least one trough-like metal enclosure is formed.

10. Arrangement according to claim 9, **characterized in that** the second metallizations (4) are respectively of half-shell design and have a plurality of edge sections (4.1, 4.2, 4.3) which form flange-like connecting regions (4') and/or **in that** the metal-ceramic substrates (1) are preferably welded or bonded to one another in the flange-like connecting regions (4') or are otherwise permanently and preferably liquid-tightly connected to one another.

11. Method for producing a metal-ceramic substrate (2) comprising at least one ceramic layer (2), in which the first surface side (2a) is bonded to at least one first metallization (3) and a second surface side (2b) opposite the first surface side (2a) is bonded to at least one second metallization (4), wherein the first metallization (3) is formed by a foil or layer of copper or a copper alloy, wherein the first metallization (3) is bonded to the first surface side (2a) of the ceramic layer (2) by means of a direct copper bonding process or by means of an active brazing process, and wherein the second metallization (4) is formed by a layer of aluminium or an aluminium alloy, which has a layer thickness of between 0.2 mm and 3.0 mm, the second metallization (4) of aluminium or an aluminium alloy being bonded either directly or via a fourth metallization (3') formed from a layer of copper or a copper alloy to the second surface side (2b) of the ceramic layer (2), **characterized in that** the second metallization (4) of aluminium or an aluminium alloy is bonded to the second surface side (2b) of the ceramic layer (2) by means of a metallization (3') formed from a layer of copper or a copper alloy and **characterized in that** a plurality of recesses (5) of different shape and/or depth are introduced into the second metallization (4) and/or the surface side of the second metallization (4) is provided with cooling elements (6) of different shape and/or height projecting outwards from the surface side.

12. Process according to claim 11, **characterized in that** the second metallization (4) is anodized.

13. Process according to claim 12 or 13, **characterized in that** the second metallization (2) and the ceramic layer (2) are bonded together by a "direct aluminium bonding" process ("DAB process") or by bonding using a plastic adhesive or a polymer suitable as an adhesive, preferably using an adhesive containing carbon fibres, in particular carbon nanofibres.

14. A process according to any of Claims 11 to 13, **characterized in that** the ceramic layer is prepared from alumina or aluminum nitride or silicon nitride or aluminum oxide with zirconia.

15. Method according to one of the claims 11 to 14, **characterized in that** the recesses (5) are introduced into the outwardly directed surface side of the second metallization (4) by means of etching, a laser treatment and/or a mechanical machining process, for example sawing.

16. Method according to claim 15, **characterized in that**, in order to enlarge the surface, recesses (5) in the form of holes with at least one hole depth of 0.05 mm are introduced into the upper side of the second metallization (4), wherein the holes are preferably arranged in a matrix-like manner, or in order to enlarge surface, recesses (5) in the form of holes extending as far as the surface of the ceramic layer (2) and/or arranged directly next to one another and/or overlapping at least partially are introduced into the surface of the ceramic layer (2).

17. Method according to one of the claims 11 to 16, **characterized in that** the second metallization (4) of a metal-ceramic substrate (1) is formed in a half-shell-like manner and is connected to the second metallization (4) of an opposite metal-ceramic substrate (1) in such a way, **in that** at least one trough-like metal enclosure (9) is formed, the two metal-ceramic substrates (1) are preferably welded or bonded to one another in a flange-like connecting region (4') of the second metallizations (4) or are otherwise permanently and preferably liquid-tightly connected to one another.

18. Method according to claim 17, **characterized in that** the metal housing (9) is accommodated in a metal housing (10) carrying a fluid or gaseous cooling medium.

## Revendications

1. Substrat métallocéramique comprenant au moins une couche céramique (2) qui est munie sur un premier côté de surface (2a) d'au moins une première métallisation (3) et sur un second côté de surface (2b) opposé au premier côté de surface (2a) d'une seconde métallisation (4), dans lequel la première métallisation (3) est formée par une feuille ou couche en cuivre ou en alliage de cuivre, la première métallisation (3) étant liée à la première face de surface (2a) de la couche céramique (2) au moyen d'un procédé de "liaison directe au cuivre" ou au moyen d'un procédé de brasage actif, et dans laquelle la seconde métallisation (4) est formée par une couche d'aluminium ou d'un alliage d'aluminium, qui présente une épaisseur de couche comprise entre 0,2 mm et 3,0 mm, la deuxième métallisation (4) d'aluminium ou d'un alliage d'aluminium étant reliée directement ou par une quatrième métallisation (3') formée d'une couche de cuivre ou d'un alliage de cuivre à la deuxième face (2b) de la couche céramique (2), **caractérisé en ce qu'**une pluralité d'évidements (5) de forme et/ou de profondeur différentes sont introduits dans la seconde métallisation (4) et/ou le côté de surface de la seconde métallisation (4) est pourvu d'éléments de refroidissement (6) de forme et/ou de hauteur différentes faisant saillie vers l'extérieur depuis le côté de surface.

2. Substrat métallocéramique selon la revendication 1, **caractérisé en ce que** la surface de la deuxième métallisation (4) de l'aluminium ou d'un alliage d'aluminium est anodisée et/ou **en ce que** la première métallisation (3) présente une épaisseur de couche comprise entre 0,1 mm et 1,0 mm, de préférence entre 0,2 mm et 0,8 mm et/ou est réalisée en surfaces de contact ou de liaison.

3. Substrat métallocéramique selon l'une des revendications 1 ou 2, **caractérisé en ce que** la seconde métallisation (4) est en forme de plaque, de feuille et/ou de demi-coque.

4. Substrat métallo-céramique selon l'une des revendications précédentes, **caractérisé en ce que** la couche céramique est constituée d'oxydes, de nitrures ou de céramiques de carbure tels que l'oxyde d'aluminium ou le nitrure d'aluminium ou le nitrure de silicium ou le carbure de silicium ou l'oxyde d'aluminium avec oxyde de zirconium et/ou a une épaisseur de couche entre 0,2 mm et 1,0 mm, de préférence entre 0,3 mm et 0,4 mm.

5. Substrat métallocéramique selon la revendication 4, **caractérisé en ce que** les évidements (5) sont en forme de canaux, de fentes, ovales, en forme de fentes, circulaires ou en forme de losanges et/ou s'étendent au moins par sections sur au moins un quart de l'épaisseur de couche de la deuxième métallisation (4), ou **en ce que** les évidements (5) pour élargir la surface de la deuxième métallisation (4) sont réalisés sous forme de trous avec au moins une profondeur de trou de 0,05 mm, la disposition des trous étant de préférence en forme de matrice.

6. Substrat métallocéramique selon la revendication 5, **caractérisé en ce que** les trous s'étendent jusqu'à la surface de la couche céramique (2) et/ou sont introduits dans la surface de la couche céramique (2) directement les uns à côté des autres et/ou se chevauchent au moins en sections.

7. Substrat métallocéramique selon la revendication 3, **caractérisé en ce que** les éléments de refroidissement (6) sont à nervures, à trous oblongs, circulaires ou en forme de losange et/ou ont une hauteur de 1 mm à 10 mm.

8. Substrat métallocéramique selon l'une des revendications précédentes, **caractérisé en ce qu'**il est prévu une troisième métallisation (7) qui est reliée sur le bord à la deuxième métallisation (4) pour former un espace de réception (8) en forme de canal pour guider un fluide de refroidissement fluide ou gazeux, et **en ce que** la troisième métallisation (7) est réalisée en aluminium, un alliage d'aluminium, en acier inoxydable, un alliage de magnésium ou en acier affiné au chrome ou nickel.

9. Agencement comprenant au moins deux substrats céramo-métalliques (1) selon l'une des revendications précédentes, **caractérisé en ce qu'**au moins l'une des secondes métallisations (4) des substrats céramo-métalliques (1) mutuellement opposés est réalisée en demi-coquille et **en ce que** les substrats céramo-métalliques (1) opposés sont reliés entre eux de manière à former au moins une enceinte métallique en auge.

10. Agencement selon la revendication 9, **caractérisé en ce que** les deuxièmes métallisations (4) sont à chaque fois en demi-coquille et présentent plusieurs sections de bord (4.1, 4.2, 4.3) qui forment des zones de liaison (4') en forme de bride et/ou **en ce que** les substrats métal-céramique (1) sont de préférence soudés ou liés les uns aux autres, ou sont reliés entre eux de façon étanche et de préférence de manière permanente dans les zones de liaison (4') en forme de bride, de façon à être reliés entre eux de façon étanche au fluide.

11. Procédé de fabrication d'un substrat céramo-métallique (2) comprenant au moins une couche céramique (2), dans lequel le premier côté de surface (2a) est lié à au moins une première métallisation (3) et un deuxième côté de surface (2b) opposé au premier côté de surface (2a) est lié à au moins une deuxième métallisation (4), dans laquelle la première métallisation (3) est formée par une feuille ou une couche de cuivre ou d'un alliage de cuivre, dans laquelle la première métallisation (3) est liée au premier côté de surface (2a) de la couche céramique (2) au moyen d'un procédé de liaison directe au cuivre ou au moyen d'un procédé de brasage actif, et dans laquelle la seconde métallisation (4) est formée par une couche d'aluminium ou un alliage d'aluminium, qui présente une épaisseur de couche comprise entre 0,2 mm et 3,0 mm, la deuxième métallisation (4) d'aluminium ou d'un alliage d'aluminium étant liée directement ou par une quatrième métallisation (3') formée d'une couche de cuivre ou d'un alliage de cuivre au deuxième côté de surface (2b) de la couche céramique (2), **caractérisé en ce que** la deuxième métallisation (4) d'aluminium ou d'alliage d'aluminium est liée au deuxième côté de surface (2b) de la couche céramique (2) par une métallisation (3') formée d'une couche de cuivre ou d'un alliage de cuivre, **en ce qu'**une pluralité d'évidements (5) de forme et/ou de profondeur différentes sont introduits dans la seconde métallisation (4) et/ou le côté de surface de la seconde métallisation (4) est pourvu d'éléments de refroidissement (6) de forme et/ou de hauteur différentes faisant saillie vers l'extérieur depuis le côté de surface.

12. Procédé selon la revendication 11, **caractérisé en ce que** la deuxième métallisation (4) est anodisée.

13. Procédé selon la revendication 12 ou 13, **caractérisé en ce que** la seconde métallisation (2) et la couche céramique (2) sont liées entre elles par un procédé de "liaison directe à l'aluminium" ("procédé DAB") ou par liaison à l'aide d'un adhésif plastique ou d'un polymère approprié comme adhésif, de préférence avec un adhésif contenant des fibres de carbone, en particulier des fibres de carbone.

14. Procédé selon l'une quelconque des revendications 11 à 13, **caractérisé en ce que** la couche céramique est préparée à partir d'alumine ou de nitrure d'aluminium ou de nitrure de silicium ou d'oxyde d'aluminium avec zircone.

15. Procédé selon l'une des revendications 11 à 14, **caractérisé en ce qu'**une pluralité d'évidements (5) de forme et/ou de profondeur différentes sont introduits dans la deuxième métallisation (4) et/ou le côté surface de la deuxième métallisation (4) est pourvu d'éléments de refroidissement (6) de forme et/ou hauteur différentes faisant saillie vers l'extérieur à partir du côté surface et/ou que les évidements (5) sont introduits dans le côté surface extérieur de la deuxième métallisation (4) par attaque, un traitement laser et/ou un usinage mécanique, par exemple le sciage.

16. Procédé selon la revendication 15, **caractérisé en ce que**, pour agrandir la surface, des évidements (5) en forme de trous ayant au moins une profondeur de trou de 0,05 mm sont introduits dans la face supérieure de la deuxième métallisation (4), les trous étant de préférence disposés en forme de matrice, ou les évidements (5) en forme de trous s'étendant jusque dans la surface de la couche céramique (2) et/ou disposés directement les uns près des autres et/ou se recouvrant au moins en partie sont introduits dans la surface de la couche céramique (2), et ce, pour élargir les évidements de surface (5) sous la forme de trous qui s'étendent jusque dans la surface de la couche céramique (2).

17. Procédé selon l'une des revendications 11 à 16, **caractérisé en ce que** la deuxième métallisation (4) d'un substrat métal-céramique (1) est formée en demi-coquille et est reliée de cette manière à la deuxième métallisation (4) d'un substrat métal-céramique opposé (1), **en ce qu'**au moins une enveloppe métallique (9) en forme de cuve est formée, les deux substrats céramo-métalliques (1) sont de préférence soudés ou collés l'un à l'autre dans une zone de liaison (4') en forme de bride des deuxièmes métallisations (4) ou sont reliés entre eux de manière permanente et de manière étanche aux liquides.

18. Procédé selon la revendication 17, **caractérisé en ce que** le boîtier métallique (9) est logé dans un boîtier métallique (10) portant un fluide de refroidissement fluide ou gazeux.
